# EUROPEAN PATENT APPLICATION

(11) **EP 4 733 696 A1**
(43) Date of publication of application: **29.04.2026**
(21) Application number: 25155015.8
(22) Date of filing: 30.01.2025
(51) Int. Cl.: F26B 3/30

(54) **INFRARED HEATER/DRYER**

(30) Priority: 25.10.2024 US 202463712094 P; 05.12.2024 US 202418970401
(71) Applicant: II-VI Delaware, Inc., Wilmington, Delaware 19801 (US)
(72) Inventor: O'Daniel, Jason Kirk, Wilmington, DE, 19801 (US); Schiattone, Francesco, Wilmington, DE, 19801 (US); Liu, Hong-Zhi, Wilmington, DE, 19801 (US); Chen, Yi-Yung, Wilmington, DE, 19801 (US)
(74) Representative: Forresters IP LLP

(57) **Abstract**

Disclosed is a heater / dryer that includes an array of one or more vertical cavity surface emitting lasers (VCSELs) disposed on a substrate. A lens assembly or array including at least one lens per VCSEL is disposed on the array of VCSELs opposite the substrate, wherein each lens is spherical or aspherical, with a convex side of the lens facing away from the array of VCSELs. The substrate may be a ceramic substrate. A side of the substrate opposite the one or more VCSELs may be coupled to an underlying substrate which may be a metal core printed circuit board (MCPCB) and/or a water cooled chiller plate. Also disclosed is a method of using the heater / dryer.

## Description

### CROSS REFERENCE TO RELATED APPLICATION

This application claims the benefit of U.S. Provisional Patent Application No. 63/712,094, filed October 25, 2024, the contents of which are incorporated herein it its entirety by reference.

### BACKGROUND

### Field

The present disclosure relates to an irradiative heater / dryer, in particular to an infrared heater / dryer based on collimated VCSELs.

### Background

One existing solution for an infrared heater / dryer is to use an array of vertical cavity surface emitting laser (VCSEL) arrays and rely on the natural divergence of the light (e.g., laser light) output by the VCSELs to overlap and provide uniform illumination. While this existing solution works, due to the high divergence (e.g., about 20°) of the light output by the VCSELs, the working distance, i.e., the distance between the VCSELs and the product to be dried or work product, is typically short, e.g., on the order of about 50-100 mm.

Another existing solution is to use arrays of edge emitting lasers with complicated projection optics. The light output by this type of configuration is diverging, so it will cover an intended area at a specific working distance, but this range will also be limited due to this divergence.

### SUMMARY

Disclosed is a VCSEL based heater / dryer, e.g., an infrared heater / dryer, that may include one or more molded collimation lenses to provide lower overall divergence of light exiting VCSELs mounted on a heat conductive substrate. The collimation lenses may be part of an illumination assembly that includes the VCSELs mounted on the heat conductive substrate. Each collimation lens may be low-cost molded lens capable of withstanding standard PCB reflow. The collimation lens may be formed by a complete over-molding of the VCSELs mounted on the heat conductive substrate or by first depositing an over-mold layer on the VCSELs mounted on the heat conductive substrate followed by attachment of individual molded lenses to the side of the over-mold layer opposite the VCSELs.

The collimation lens may be designed to operate at a slight defocus such that a crisp, sharp, or focused image of the light output by the VCSELs is not formed on a work piece disposed at a target operating distance from the heater / dryer in order to provide better uniformity.

Multiple illumination assemblies may be arrayed to make up the heater / dryer. The collimation lenses of each illumination assembly may provide a larger range of possible working distances as the light and hence the power from the VCSELs is not spreading out as quickly as would be the case if the VCSELs where used without the collimation lenses. This also may mean that the work piece may be disposed further from the heater / dryer, which may result in the heater / dryer being less likely to become contaminated by any loose particulates or condensates during drying of the work piece.

### BRIEF DESCRIPTION OF THE DRAWINGS

Fig 1 is a perspective view of a single illumination assembly, in accordance with the principles of the present disclosure, of a heater / dryer, also in accordance with the principles of the present disclosure;
Figs. 2A- 2B are cross-sections the illumination assembly of Fig. 1 in different states of assembly;
Fig. 3 is a perspective view of an example heater / dryer in accordance with the principles of the present disclosure formed from an array of the illumination assemblies shown in Fig. 1;
Figs. 4A - 4B are models of irradiance of the example heater / dryer of Fig. 3 without lenses at a working distances of 55 mm and 105 mm between the top side of the heater / dryer and the work piece 16 also shown in Fig. 3; and
Figs. 4C - 4D are models of irradiance of the example heater / dryer of Fig. 3 with lenses at working distances 200 mm and 400 mm between the top side of the heater / dryer 4 shown in Fig. 3 and the work piece 16 shown in Fig. 3.

### DETAILED DESCRIPTION

Various non-limiting embodiments will now be described with reference to the accompanying figures where like reference numbers correspond to like or functionally equivalent elements or features.

As used herein, spatial, or directional terms, such as "left", "right", "inner", "outer", "above", "below", "top", "bottom", and the like, relate to the disclosure as it is shown in the drawing figures. However, it is to be understood that the disclosure can assume various alternative orientations and, accordingly, such terms are not to be considered as limiting. Further, as used herein, all numbers expressing dimensions, physical characteristics, processing parameters, quantities of ingredients, reaction conditions, and the like, used in the specification and claims are to be understood as being modified in all instances by the term "approximately" or "about". Accordingly, unless indicated to the contrary, the numerical values set forth in the following specification and claims may vary depending upon the desired properties sought to be obtained by the present disclosure.

At the very least, and not as an attempt to limit the application of the doctrine of equivalents to the scope of the claims, each numerical value should at least be construed in light of the number of reported significant digits and by applying ordinary rounding techniques. Moreover, all ranges disclosed herein are to be understood to encompass the beginning and ending range values and any and all subranges subsumed therein. For example, a stated range of "1 to 10" should be considered to include any and all subranges between (and inclusive of) the minimum value of 1 and the maximum value of 10; that is, all subranges beginning with a minimum value of 1 or more and ending with a maximum value of 10 or less, e.g., 1 to 3.3, 4.7 to 7.5, 5.5 to 10, and the like. "A" or "an" refers to one or more.

As used herein, "coupled", "coupling", and similar terms refer to two or more elements that are joined, linked, fastened, connected, put in communication, or otherwise associated (e.g., mechanically, electromagnetically, fluidly, optically, electromagnetic) with one another. In various examples, the elements may be associated directly or indirectly. As an example, element A may be directly associated with element B. As another example, element A may be indirectly associated with element B, for example, via another element C. It will be understood that not all associations among the various disclosed elements are necessarily represented. Accordingly, couplings other than those depicted in the figures may also exist.

As used herein, the phrase "at least one of', when used with a list of items, means different combinations of one or more of the listed items may be used and only one of each item in the list may be needed. For example, "at least one of item A, item B, and item C" may include, without limitation, item A or item A and item B. This example also may include item A, item B, and item C, or item B and item C. In other examples, "at least one of" may be, for example, without limitation, two of item A, one of item B, and ten of item C; four of item B and seven of item C; and other suitable combinations.

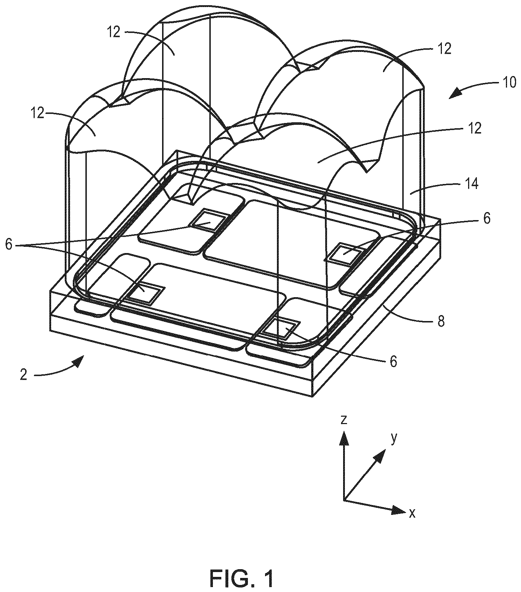

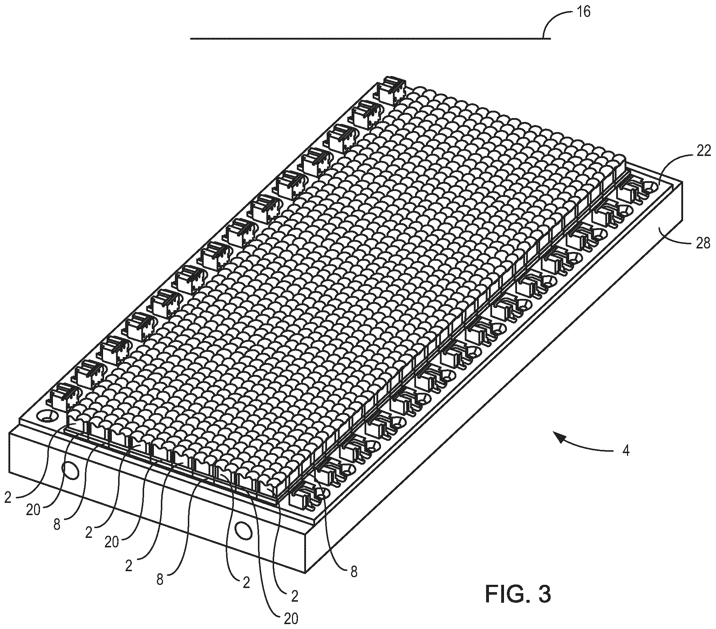

With reference to Fig. 1, single illumination assembly 2, in accordance with the principles of the present disclosure, of a heater / dryer 4 (shown in Fig. 3), also in accordance with the principles of the present disclosure, may include an array of one or more VCSELs 6 supported by a heat conductive substrate 8, for example, a ceramic substrate. While the illumination assembly 2 shown in Fig. 1 includes a 2 x 2 array of VCSELs 6, this is not to be construed as limiting the present disclosure since it is envisioned that the array of VCSELs 6 may include any number of one or more VCSELs 6 in a X x Y array, where X ≥ 1 and Y ≥ 0. Strictly for the purpose of illustration, the present disclosure will described in connection the 2 x 2 array of VCSELs 6 shown in Fig. 1. However, this is not to be construed as limiting the present disclosure.

Disposed on a side of the array of VCSELs 6 opposite the heat conductive substrate 8 the illumination assembly 2 may include a lens assembly or array 10 comprising one or more lenses 12. While the lens assembly or array 10 shown in Fig. 1 includes a 2 x 2 array of lenses 12, this is not to be construed as limiting the present disclosure since it is envisioned that the lens assembly or array 10 may include any number of one or more lenses 12 in a X x Y array, where X ≥ 1 and Y ≥ 0. Strictly for the purpose of illustration, the present disclosure will be described in connection to the 2 x 2 array of lenses 12 shown in Fig. 1. However, this is not to be construed as limiting the present disclosure.

In an example, multiple VSCELs 6 in a single illumination assembly 2 may be preferred due to lower cost per unit of output power. However, too large of an illumination assembly 2 may result in a thermal expansion mismatch between the lens assembly or array 10 and lenses 12 and the array of VCSELs 6 supported by the heat conductive substrate 8. Accordingly, in an example, the heater / dryer 4 shown in Fig. 3 may include a 2 x 2 array of VCSELs 6 per illumination assembly 2.

In an example, the lens assembly or array 10 may be molded from any suitable and/or desirable material having a desirable index of refraction. The lens assembly or array 10 may be formed by over-molding the array of VCSELs 6 supported by the heat conductive substrate 8 with the entire lens assembly or array 10 comprising the lenses 12 or by first depositing an over-mold layer 14 on the array of VCSELs 6 followed by the attachment of individual lenses 12 to a side of the over-mold layer 14 opposite the VCSELs 6. In an example, the lens assembly or array 10 and lenses 12 may be made from Polydimethylsiloxane (PDMS) with an index of refraction n of about 1.41, e.g., n = 1.41 ± 0.05.

In an example, the lenses 12 may be configured to operate at a defocus in the Z direction whereupon a crisp, sharp, or focused image of the light output by VCSEL array may not be formed on a work piece 16 (shown as a line in Fig. 3) to be heated / dried disposed, on a side of the lens assembly or array 10 opposite the array of VCSELs 6 supported by the heat conductive substrate 8, at a target or desired operating distance in order to provide better uniformity. Stated differently, the light output by VCSEL array to the work piece 16 via the lens assembly or array 10, disposed at the target or desired operating distance, is out-of-focus at the surface of the work piece 16 that faces the lens assembly or array 10.

Multiple illumination assemblies 2 may be arrayed to form the example heater / dryer 4 shown in Fig. 3, i.e., a 10 x 28 array of illumination assemblies 2. The lens assembly or array 10 of each illumination assembly 2 of the example heater / dryer 4 shown in Fig. 3 may provide a larger range of possible working distances as the light and, hence, the power is not spreading out as quickly as in prior art infrared heaters / dryers. This also means that the work piece 16 may be disposed further from the heater / dryer 4, which may also avoid contamination of the work piece 16 by loose particulates or condensates that may be present.

In an example, each lens 12 of the lens assembly or array 10 may be positioned or disposed over an individual VCSEL 6. Each lens 12 may be spherical or aspherical and may include a concave side of the lens 12 facing the VCSEL 6 and a convex side of the lens 12 facing away from the VCSEL 6.

In an example, the position of the lens 12 may be offset or defocused in the Z direction to provide blurring of the VCSEL image as the heating / drying application may require the infrared heat on the work piece 16 to be as uniform as possible. The design of the lens 12 of each illumination subassembly 2 may be varied slightly to provide some additional defocusing differences to aid with uniformity of the heating / drying.

In an example, the heat conductive substrate 8 of each illumination assembly 2 may be made of a high thermal conductivity material, such as, for example, ceramic, that may provide a good thermal path from the VCSELs 6 to the heat conductive substrate 8 which, in an example, may also be electrical isolating so that the VCSELs 6 can be electrically connected, e.g., in series, as may deemed needed, suitable, and/or desirable to apply an electrical stimulus to the VCSELs 6. In another example, the heat conductive substrate 8 of each illumination assembly 2 may be made of a molded copper lead-frame or printed circuit board (PCB) with embedded copper slugs, with electrical isolation occurring in a metal core PCB (MCPCB) (discussed hereinafter in connection with Fig. 3) to which these the heat conductive substrate 8 may be attached.

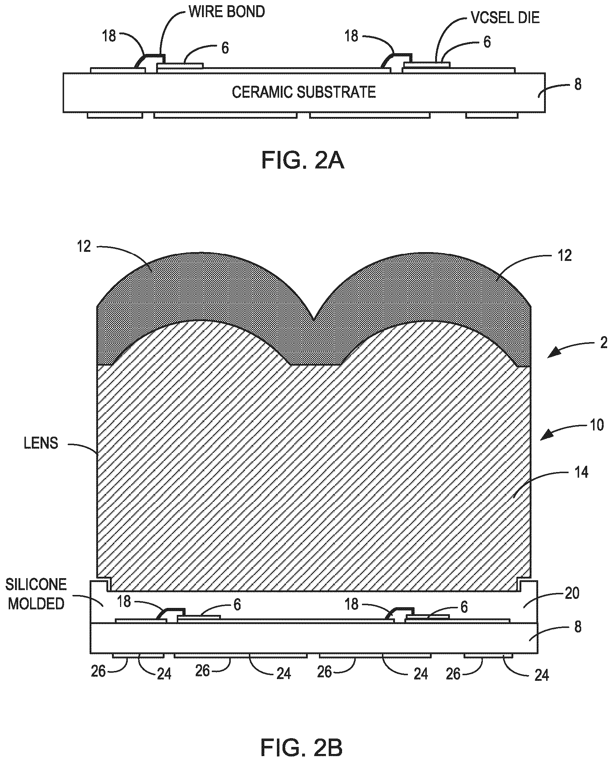

A method of forming an example illumination assembly 2 will now be described with reference to Figs 2A-2B.

First, VCSELs (for example, VCSEL dies) 6 may be attached to a heat conductive substrate 8, such as a ceramic substrate, and then wire bonds 18 may be attached for electrical connection between the VCSELs 6 and the heatsink 8. The heat conductive substrate 8 may include a suitable pattern of conductors (e.g., screen printed conductors) to which the VCSELs 6 and wire bonds 18 make electrical connections. These conductors may be formed in a manner known in the art to allow suitable electrical biases from one or more external electrical sources (not shown) and ground (not shown) to be applied to the VCSELs 6, via the wire bonds 18 and the backsides of the VCSELs 6, to electrically stimulate the VCSELs 6 to produce light in a manner know in the art.

Next, a silicone interface 20 may molded over the VCSEL 6 side of the heat conductive substrate 8 to protect the VCSELs 6 and provide a location or locations for the lens(es) 12. Thereafter, one or more molded lens assemblies or arrays 10, wherein each molded lens assembly or array 10 includes one or more lenses 12, may be attached to the side of the silicone interface 20 opposite the VCSELs 6 to form a completed illumination assembly 2. It is envisioned that these latter two steps may be combined into a single step as may be possible, suitable, and/or desirable.

With reference to Fig. 3 and with continuing reference to all previous figures, next, a number of completed illumination assemblies 2 may be attached (e.g., via surface mounting and reflow processes) to a metal core PCB (MCPCB) 22 which, in-turn, may be coupled to a water cooled chiller plate 28, to form a complete heater / dryer 4.

The complete heater / dryer 4 may comprise an array, e.g., without limitation, a 10 x 28 array, of illumination assemblies 2 attached to the MCPCB 22 via their respective heat conductive substrates 8, each of which may include a thin layer of solder 26 on attachment pads 24 of the heat conductive substrate 8 to minimize or avoid tilt of the illumination assemblies 2. The side of the MCPCB 22 opposite the illumination assemblies 2 may then be secured to the water cooled chiller plate 28 to aid in cooling the combination of the complete heater / dryer 4 during use.

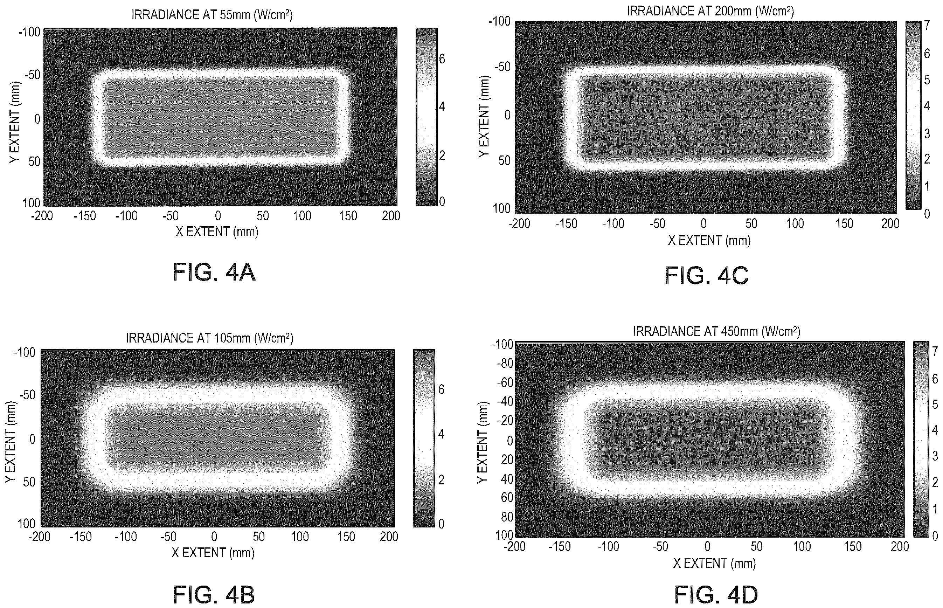

With reference to Figs. 4A - 4B and with continuing reference to all previous figures, as can be seen, models of the irradiance pattern of the example heater / dryer of Fig. 3 without lens assemblies or arrays 10 including lenses 12 at a working distance of 55 mm (Fig. 4A) and 105 mm (Fig. 4B) between the top side of the heater / dryer 4 and the work piece 16 are similar, with the irradiance pattern shown in Fig. 4B being more defocused than the irradiance pattern shown in Fig. 4A.

With reference to Figs. 4C - 4D, and with continuing reference to all previous figures, as can also be seen, models of the irradiance pattern of the example heater / dryer of Fig. 3 with lens assemblies or arrays 10 including lenses 12 at a working distance of 200 mm (Fig. 4C) and 450 mm (Fig. 4D) between the top side of the heater / dryer 4 and the work piece 16 are similar to the models of the irradiance pattern of the example heater / dryer of Fig. 3 without lens assemblies or arrays 10 including lenses 12 show in Figs. 4A- 4B. As can also be seen, the illustrated irradiance patterns are similar, but in Fig. 4D the larger working distance is more desirable than the irradiance pattern shown in Fig. 4B. Thus, as can be understood, the same configuration of the heater / dryer 4 with the lens assemblies or arrays 10 including lenses 12 may have, as shown in Figs. 4C - 4D, a working distance that may be between about 3x - 6x the working distance of the heater / dryer 4 without the lens assemblies or arrays 10 including lenses 12, as shown in Figs. 4A - 4B, with similar irradiance patterns.

A method of heating or drying the work piece 16 may include providing the heater / dryer 4 and positioning the work piece 16 in spaced relation to a side of the lens assembly or array 10 opposite the substrate 8 at a distance whereupon light emitted by the array of one or more VCSELs 6 to the work piece 16 through the lens assembly or array 10 is out-of-focus at a surface of the work piece 16 that faces the lens assembly or array 10. Then, the one or more VCSELs 6 may be caused to emit light to the surface of the work piece 6 that faces the lens assembly or array 10.

Other non-limiting examples or aspects of this disclosure are set forth in the following illustrative and exemplary numbered clauses:
Clause 1: A heater / dryer comprising: an array of one or more VCSELs disposed on a substrate; and a lens assembly or array including at least one lens per VCSEL disposed on the array of VCSELs opposite the substrate, wherein each lens is spherical or aspherical, with a convex side of the lens facing away from the VCSEL.
Clause 2: The heater / dryer of clause 1, wherein the substrate may be a ceramic substrate.
Clause 3: The heater / dryer of clause 1 or 2 may further include a side of the substrate opposite the one or more VCSELs disposed on an underlying substrate.
Clause 4: The heater / dryer of any one of clauses 1-3, wherein the underlying substrate may include a metal core printed circuit board (MCPCB), a water cooled chiller plate, or both.
Clause 5: The heater / dryer of any one of clauses 1-4, wherein: the array of one or more VCSELs disposed on the substrate and the lens assembly or array including at least one lens per VCSEL disposed on the array of VCSELs opposite the substrate may form an illumination assembly; and the heater / dryer may comprise an array of two or more illumination assemblies disposed on an underlying substrate.
Clause 6: The heater / dryer of any one of clauses 1-5, wherein the underlying substrate may include a metal core printed circuit board (MCPCB), a water cooled chiller plate, or both.
Clause 7: The heater / dryer of any one of clauses 1-6, wherein the array of illumination assemblies may be disposed on a side of the MCPCB opposite the water cooled chiller plate.
Clause 8: The heater / dryer of any one of clauses 1-7, wherein light emitted by the array of one or more VCSELs to a work piece disposed on a side of the lens assembly or array opposite the substrate may be out-of-focus at a surface of the work piece that faces the lens assembly or array
Clause 9: The heater / dryer of any one of clauses 1-8, wherein the lens assembly or array may comprise an over-mold layer disposed on the array of one or more VCSELs and at least one lens per VCSEL disposed on a side of the over-mold layer opposite the substrate.
Clause 10: The heater / dryer of any one of clauses 1-9, wherein the lens assembly or array may be made from Polydimethylsiloxane (PDMS).
Clause 11: The heater / dryer of any one of clauses 1-10, wherein the lens assembly or array may have an index of refraction of 1.41.
Clause 12: A method of heating or drying a work piece comprising: providing the heater / dryer of any one of clauses 1-11; positioning a work piece in spaced relation to a side of the lens assembly or array opposite the substrate at a distance whereupon light emitted by the array of one or more VCSELs to the work piece through the lens assembly or array is out-of-focus at a surface of the work piece that faces the lens assembly or array; and causing the one or more VCSELs to emit light to the surface of the work piece that faces the lens assembly or array.

Although this disclosure has been described in detail for the purpose of illustration based on what is currently considered to be the most practical and preferred embodiments, it is to be understood that such detail is solely for that purpose and that the disclosure is not limited to the disclosed embodiments, but, on the contrary, is intended to cover modifications and equivalent arrangements that are within the spirit and scope of the appended claims. For example, it is to be understood that the present disclosure contemplates that, to the extent possible, one or more features of any embodiment can be combined with one or more features of any other embodiment.

## Claims

1. A heater / dryer comprising:
an array of one or more VCSELs disposed on a substrate; and
a lens assembly or array including at least one lens per VCSEL disposed on the array of VCSELs opposite the substrate, wherein each lens is spherical or aspherical, with a convex side of the lens facing away from the VCSEL.

2. The heater / dryer of claim 1, wherein the substrate is a ceramic substrate.

3. The heater / dryer of claim 1 or 2, further including a side of the substrate opposite the one or more VCSELs disposed on an underlying substrate.

4. The heater / dryer of claim 3, wherein the underlying substrate includes a metal core printed circuit board (MCPCB), a water cooled chiller plate, or both.

5. The heater / dryer of any of claims 1-4, wherein:
the array of one or more VCSELs disposed on the substrate and the lens assembly or array including at least one lens per VCSEL disposed on the array of VCSELs opposite the substrate form an illumination assembly; and
the heater / dryer comprises an array of two or more illumination assemblies disposed on an underlying substrate.

6. The heater / dryer of claim 5, wherein the underlying substrate includes a metal core printed circuit board (MCPCB), a water cooled chiller plate, or both.

7. The heater / dryer of claim 6, wherein the array of illumination assemblies is disposed on a side of the MCPCB opposite the water cooled chiller plate.

8. The heater / dryer of any of claims 1-7, wherein light emitted by the array of one or more VCSELs to a work piece disposed on a side of the lens assembly or array opposite the substrate is out-of-focus at a surface of the work piece that faces the lens assembly or array.

9. The heater / dryer of any of claims 1-8, wherein the lens assembly or array comprises an over-mold layer disposed on the array of one or more VCSELs and at least one lens per VCSEL disposed on a side of the over-mold layer opposite the substrate.

10. The heater / dryer of any of claims 1-9, wherein the lens assembly or array is made from Polydimethylsiloxane (PDMS).

11. The heater / dryer of any of claims 1-10, wherein the lens assembly or array has index of refraction of 1.41.

12. A method of heating or drying a work piece comprising:
providing the heater / dryer of claim any of claims 1-11;
positioning a work piece in spaced relation to a side of the lens assembly or array opposite the substrate at a distance whereupon light emitted by the array of one or more VCSELs to the work piece through the lens assembly or array is out-of-focus at a surface of the work piece that faces the lens assembly or array; and
causing the one or more VCSELs to emit light to the surface of the work piece that faces the lens assembly or array.

## Amended claims

### Amended claims in accordance with Rule 137(2) EPC.

1. A heater / dryer (4) comprising:
an array of one or more VCSELs (6) disposed on a heat conductive substrate (8);
a lens assembly or array (10) including at least one lens (12) per VCSEL disposed on the array of VCSELs (6) opposite the heat conductive substrate (8), wherein each lens (12) is spherical or aspherical, with a convex side of the lens facing away from the VCSEL (6);
wherein the array of one or more VCSELs (6) disposed on the heat conductive substrate (8) and the lens assembly or array (10) including at least one lens (12) per VCSEL disposed on the array of VCSELs (6) opposite the heat conductive substrate (8) form an illumination assembly (2); and the heater / dryer (4) comprises an array of two or more illumination assemblies (2) disposed on an underlying substrate (22);
wherein light emitted by the array of one or more VCSELs (6) to a work piece (16) disposed on a side of the lens assembly or array (10) opposite the heat conductive substrate (8) is out-of-focus at a surface of the work piece (16) that faces the lens assembly or array (10); and
wherein the lens assembly or array comprises an over-mold layer (14) disposed on the array of one or more VCSELs (6) and at least one lens (12) per VCSEL disposed on a side of the over-mold layer (14) opposite the heat conductive substrate (8).

2. The heater / dryer of claim 1, wherein the heat conductive substrate (8) is a ceramic heat conductive substrate.

3. The heater / dryer of claim 1, wherein the underlying substrate (22) includes a metal core printed circuit board (MCPCB), a water cooled chiller plate (28), or both.

4. The heater / dryer of claim 3, wherein the array of illumination assemblies (2) is disposed on a side of the MCPCB opposite the water cooled chiller plate (28).

5. The heater / dryer of any of claims 1-4, wherein the lens assembly or array (10) is made from Polydimethylsiloxane (PDMS).

6. The heater / dryer of any of claims 1-5, wherein the lens assembly or array (10) has index of refraction of 1.41.

7. A method of heating or drying a work piece (16) comprising:
providing the heater / dryer of any of claims 1-6;
positioning a work piece (16) in spaced relation to a side of the lens assembly or array (10) opposite the heat conductive substrate (8) at a distance whereupon light emitted by the array of one or more VCSELs (6) to the work piece (16) through the lens assembly or array (10) is out-of-focus at a surface of the work piece (16) that faces the lens assembly or array (10); and
causing the one or more VCSELs (6) to emit light to the surface of the work piece (16) that faces the lens assembly or array (10).
